(19) **Europäisches Patentamt**

**European Patent Office**

**Office européen des brevets**

(11) **EP 0 782 272 B1**

(12) **FASCICULE DE BREVET EUROPEEN**

(45) Date de publication et mention
de la délivrance du brevet:
**11.09.2002 Bulletin 2002/37**

(51) Int Cl.⁷: **H03M 1/06**

(21) Numéro de dépôt: **96402782.5**

(22) Date de dépôt: **18.12.1996**

(54) **Circuit de traitement numérique à contrôle de gain**

Digitale Verarbeitungsschaltung mit Verstärkungsregelung

Digital processing circuit with gain control

(84) Etats contractants désignés:
**DE FR GB IT**

(30) Priorité: **29.12.1995 FR 9515745**

(43) Date de publication de la demande:
**02.07.1997 Bulletin 1997/27**

(73) Titulaire: **THOMSON multimedia**
**92648 Boulogne Cédex (FR)**

(72) Inventeur: **Delmas, Christian**
**92050 Paris La Defense Cedex (FR)**

(74) Mandataire: **Ruellan-Lemonnier, Brigitte et al**
**THOMSON multimedia,**
**46 quai A. Le Gallo**
**92648 Boulogne Cédex (FR)**

(56) Documents cités:
**US-A- 4 598 269**     **US-A- 5 369 403**

- **PATENT ABSTRACTS OF JAPAN vol. 018, no. 661 (E-1644), 14 Décembre 1994 & JP-A-06 260936 (MITSUBISHI ELECTRIC CORP), 16 Septembre 1994,**
- **TIETZE, U.; SCHENK, C.: "Halbleiter-Schaltungstechnik", 1980, SPRINGER VERLAG, BERLIN**
- **'Data Sheet: AD7574' ANALOG DEVICES NORWOOD, MA, page 1**

## Description

L'invention concerne un circuit de traitement numérique dont l'entrée est constituée d'un convertisseur analogique/numérique et dont la sortie est constituée d'un convertisseur numérique/analogique.

Plus particulièrement, l'invention concerne un circuit permettant de contrôler le gain d'un circuit de traitement numérique tel que celui mentionné ci-dessus.

L'invention s'applique à tout type d'équipement audio ou vidéo utilisant de tels circuits tel que, par exemple, les récepteurs de télévision, les magnétoscopes ou les décodeurs satellites, etc.

Les circuits de traitement selon l'invention sont donc constitués de trois circuits élémentaires : un convertisseur analogique/numérique, un dispositif de traitement numérique, un convertisseur numérique/analogique.

Un tel circuit est notamment décrit dans le document "Patent Abstracts of Japan, vol. 018, No. 661 (E-1644), 14 décembre 1994 & JP-A-06 260 936 (MITSUBISHI ELECTRIC CORP), 16 décembre 1994".

Deux types de configuration sont actuellement connus de l'homme de l'art afin de réaliser ces circuits de traitement.

Une première configuration consiste à réaliser les trois circuits élémentaires séparément et à les assembler pour constituer le circuit de traitement. Selon cette première configuration, chaque convertisseur analogique/numérique et numérique/analogique a son gain contrôlé par une référence qui lui est propre. Il s'agit d'un circuit de contrôle intégré ou non au circuit élémentaire que constitue le convertisseur.

Généralement, la référence qui permet le contrôle du gain est réalisée par un circuit spécifique à partir de la tension d'alimentation du convertisseur.

Selon la précision demandée sur le contrôle de gain, il est alors nécessaire de réaliser des circuits spécifiques plus ou moins complexes et encombrants.

Une autre manière de réaliser le contrôle de gain est d'utiliser une référence de tension interne au composant que constitue le convertisseur. Cette référence de tension interne est connue de l'homme de l'art sous la dénomination de tension de "bandgap". Cependant, selon certaines technologies telles que, par exemple, la technologie CMOS, les tensions de "bandgap" sont difficilement reproductibles d'un composant à l'autre. La différence entre deux tensions de "bandgap" réalisées pour deux composants différents peut en effet atteindre, voire dépasser, la valeur de 10 %. Il s'ensuit une grande dispersion des gains relatifs à différents circuits.

Une deuxième configuration consiste à réaliser les trois circuits élémentaires à l'aide de deux composants : le convertisseur analogique/numérique constitue un premier composant et l'ensemble constitué par le dispositif de traitement numérique et le convertisseur numérique/analogique constitue un deuxième composant.

Le contrôle de gain du circuit de traitement est alors assuré par un contrôle de gain au niveau de chacun des deux composants.

La référence qui permet le contrôle de gain de chaque composant est réalisée comme cela a été mentionné ci-dessus, c'est-à-dire soit à l'aide de circuits spécifiques donnant une bonne précision mais relativement complexes et encombrants, soit à l'aide de tensions de "bandgap" difficilement reproductibles.

L'invention ne présente pas ces inconvénients.

La présente invention propose un circuit de traitement numérique comprenant un convertisseur analogique/numérique situé en entrée du circuit, un dispositif de traitement numérique du signal issu du convertisseur analogique/numérique, et un convertisseur numérique/analogique situé en sortie du circuit pour convertir le signal issu du dispositif de traitement numérique. Selon l'invention, le circuit de traitement numérique comprend des moyens pour contrôler le gain dudit circuit à partir d'une référence unique de tension de sorte que le gain du circuit de traitement soit indépendant de la tension de référence unique.

Préférentiellement, la référence unique de tension est une tension de « bandgap » et le circuit est réalisé en technologie CMOS.

De façon plus générale, le circuit selon l'invention peut cependant être réalisé à l'aide d'autres technologies.

Des modes de réalisation particuliers de l'invention apparaissent dans les revendications dépendantes 2, 3 et 5 à 9.

D'autres caractéristiques et avantages de l'invention apparaîtront à la lecture d'un mode de réalisation préférentiel pris à titre d'exemple non limitatif et fait en référence aux figures ci-annexées, parmi lesquelles :

- La figure 1 représente un premier exemple du mode de réalisation de l'invention.
- La figure 2 représente un deuxième exemple du mode de réalisation de l'invention.

Sur toutes les figures, les mêmes repères désignent les mêmes éléments.

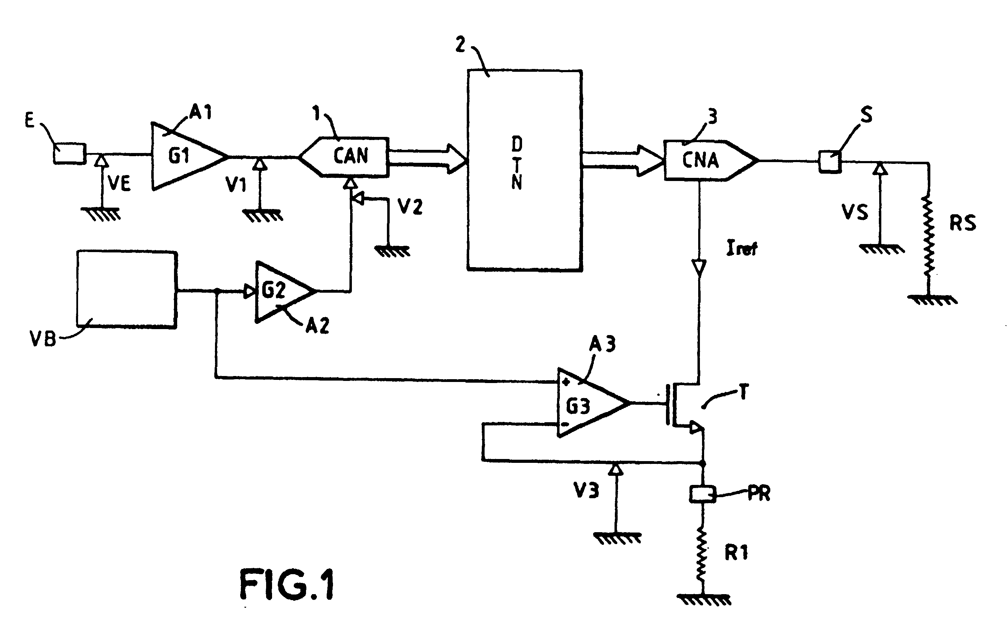

La figure 1 représente un premier exemple du mode de réalisation de l'invention.

Le circuit de traitement est constitué d'un convertisseur analogique/numérique 1, d'un dispositif de traitement numérique 2, et d'un convertisseur numérique/analogique 3. Selon le mode de réalisation de la figure 1, le convertisseur numérique/analogique 3 est commandé en courant afin de faciliter les opérations de commutation. Avantageusement, une seule référence de tension VB est utilisée pour fournir à la fois la tension de référence V2 du convertisseur analogique/numérique et le courant de référence Iref du convertisseur numérique/analogique.

La tension de référence V2 est issue de l'amplificateur A2 de gain G2 qui reçoit sur son entrée la tension VB. Il vient donc :

$$V2 = G2 \times VB.$$

La tension VB est envoyée sur l'entrée positive de l'amplificateur différentiel A3 dont l'entrée négative est reliée, d'une part, à la masse du circuit par l'intermédiaire de la résistance R1 et, d'autre part, à la source d'un transistor T. La grille et le drain du transistor T sont respectivement reliés à la sortie de l'amplificateur différentiel A3 et au point du convertisseur numérique/analogique d'où est extrait le courant de référence Iref. L'amplificateur différentiel de gain G3 très élevé est tel que V+ = V- où V+ et V- sont respectivement la tension appliquée à l'entrée positive et la tension appliquée à l'entrée négative de l'amplificateur différentiel A3.

Il s'ensuit que la tension V3 recueillie aux bornes de la résistance R1 est égale à la tension VB. Le courant de référence Iref est alors tel que :

$$Iref = \frac{VB}{R1}.$$

Comme cela est connu de l'homme de l'art, le courant de sortie IS qui traverse la résistance RS qui charge la sortie du convertisseur numérique/analogique 3 s'écrit :

$$IS = Im \times \frac{N}{2^n - 1},$$

où :

- Im = $k \times$ Iref, lm représentant le courant maximum disponible en sortie du dispositif de traitement, k étant un coefficient associé à la structure du convertisseur numérique/analogique,

- N représente le rang du code binaire converti, c'est-à-dire un nombre entier compris entre 0 et $2^n-1$ pour un convertisseur de n bits,

- $2^n-1$ représente le rang maximum que peut prendre le code binaire converti.

La tension VS recueillie sur la sortie S du circuit de traitement s'écrit alors :

$$VS = RS \times k \times Iref \times \frac{N}{2^n - 1}.$$

Or,

$$Iref = \frac{VB}{R1},$$

il vient donc :

$$VS = RS \times k \times \frac{VB}{R1} \times \frac{N}{2^n - 1}.$$

Préférentiellement, le circuit de traitement comprend sur son entrée un amplificateur A1 de gain G1. Il s'ensuit que la tension V1 à l'entrée du convertisseur analogique/numérique 1 est telle que :

$$V1 = G1 \times VE,$$

où VE est la tension appliquée à l'entrée E du circuit de traitement.

Comme cela est connu de l'homme de l'art, la tension V1 à l'entrée du convertisseur 1 s'écrit :

$$V1 = N \times \Delta V,$$

où N est le rang du code binaire comme cela a été mentionné précédemment et $\Delta V$ le pas élémentaire de la tension analogique à convertir.

Il vient donc :

$$VE = \frac{N \times \Delta V}{G1},$$

or

$$\Delta V = \frac{V2}{2^n - 1} \text{ et } V2 = G2 \times VB.$$

Il s'ensuit

$$VE = \frac{N \times G2 \times VB}{G1 \times 2^{n-1}}.$$

Le gain du circuit de traitement s'écrit donc :

$$G = \frac{VS}{VE},$$

soit :

$$G = \frac{RS}{R1} \times \frac{G1}{G2} \times k.$$

Comme cela apparaît sur la formule donnant le gain G, la valeur de G ne dépend pas de la valeur de la tension de référence VB.

Avantageusement, la valeur du gain des circuits de traitement selon l'invention n'est pas affectée par la difficulté qu'il peut y avoir à reproduire la valeur de la tension VB.

Selon le mode de réalisation préférentiel, les différents éléments que constituent les amplificateurs A1, A2, A3, le transistor T, les convertisseurs 1 et 3 et le dispositif de traitement numérique 2 sont intégrés au sein d'un même composant réalisé en technologie CMOS. Comme cela a été mentionné précédemment, la tension de référence VB est alors une tension de "bandgap" interne au composant et dont les variations peuvent atteindre, voire dépasser, 10 % d'un composant à l'autre.

Avantageusement, les valeurs de gains associées à différents circuits de traitement réalisés en technologie CMOS ne sont alors pas affectées par les variations de la tension de "bandgap".

Selon l'invention, les résistances R1 et RS peuvent être ou non intégrées au composant que constitue le circuit de traitement.

Dans le cas où les résistances R1 et RS ne sont pas intégrées au composant, la valeur du gain du circuit de traitement est réglable en modifiant la valeur des résistances. Avantageusement, le réglage de la valeur du gain selon l'invention est alors simplifié par rapport au réglage à mettre en oeuvre avec les circuits de l'art antérieur.

La précision sur la valeur du gain G dépend de la précision des résistances RS et R1, des gains G1 et G2 et du coefficient k. De façon générale, les valeurs des gains G1 et G2 et du coefficient k sont facilement reproductibles. Il s'ensuit que la précision sur la valeur du gain G ne dépend le plus souvent que de la précision des résistances RS et R1. Ainsi, l'utilisateur peut-il choisir, par exemple, des résistances à 5 % pour des applications n'exigeant pas une grande précision ou, au contraire, des résistances à 0,1 % pour des applications exigeant une grande précision. Dans ce dernier cas, c'est-à-dire le cas où les résistances sont de grande précision, les gains obtenus pour différents circuits de traitement ont des valeurs reproductibles dans une fourchette inférieure ou égale à 2 %.

Selon un mode de réalisation particulier, le circuit de traitement ne contient pas d'amplificateurs A1 et A2. Il s'ensuit que les gains G1 et G2 qui apparaissent dans l'expression de G sont tous deux égaux à 1. Cette application correspond à une dynamique de codage égale à la tension de référence puisqu'alors V2 est égal à VB. Le gain du circuit de traitement ne dépend alors exclusivement que des résistances RS et R1 et du facteur k. La variation de gain G d'un circuit à l'autre peut alors être rendue très faible.

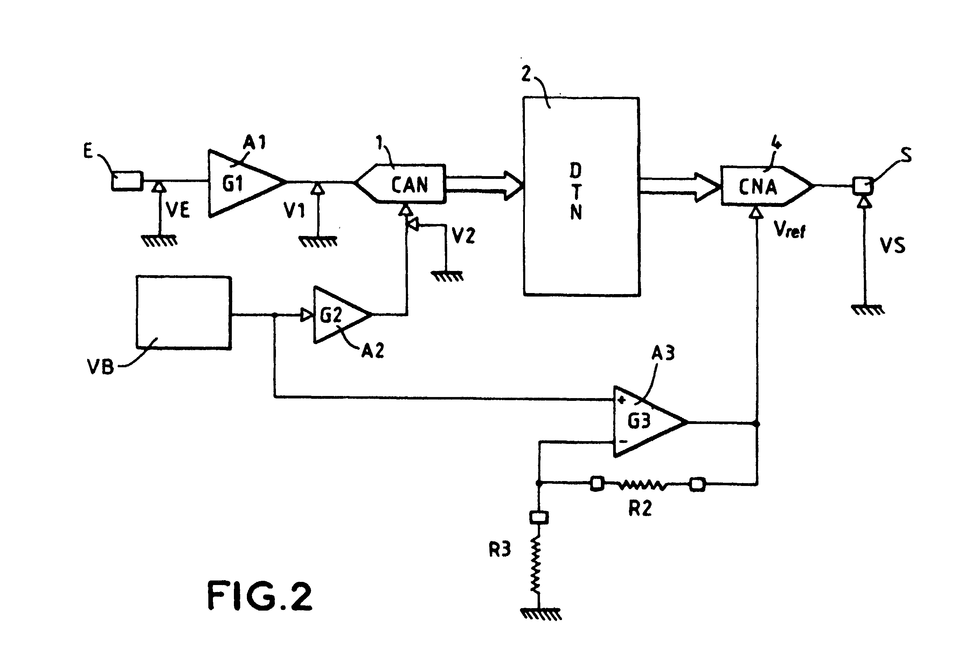

La figure 2 représente un deuxième exemple du mode de réalisation de l'invention.

Selon ce deuxième mode de réalisation, le convertisseur numérique/analogique 4 de sortie est commandé par une tension de référence Vref. La tension de référence Vref est obtenue à partir de la tension VB.

A cette fin, la tension VB est envoyée sur l'entrée positive de l'amplificateur différentiel A3 dont l'entrée négative est reliée, d'une part, à la masse du circuit par l'intermédiaire d'une résistance R3 et, d'autre part, à la sortie de l'amplificateur A3 par l'intermédiaire d'une résistance R2.

La tension de référence Vref est la tension obtenue en sortie de l'amplificateur A3.

Il vient alors :

$$Vref = G_0 \times VB,$$

où $G_0$ est égal à $1 + \frac{R2}{R3}$.

La tension de sortie VS du convertisseur numérique/analogique est donnée par l'expression :

$$VS = \frac{N}{2^n - 1} \times Vref.$$

Au niveau du convertisseur analogique/numérique d'entrée, le circuit décrit en figure 2 est identique au circuit décrit en figure 1. Il s'ensuit que l'expression de la tension d'entrée VE s'écrit aussi :

$$VE = \frac{N \times G2 \times VB}{G1 \times 2^{n-1}}.$$

En conséquence, l'expression du gain G qui est le rapport de la tension VS à la tension VE s'écrit :

$$G = \frac{G1}{G2} \times G_0.$$

De même que dans le cas de la figure 1, les différents éléments que sont les amplificateurs A1, A2, A3, les convertisseurs 1 et 4 et le dispositif de traitement numérique 2 peuvent être intégrés au sein d'un même composant et réalisés à l'aide d'une même technologie, par exemple la technologie CMOS. Avantageusement, les résistances R2 et R3 peuvent soit être intégrées au composant que constitue le circuit de traitement, soit être des éléments extérieurs au composant.

Avantageusement, dans le cas où les résistances R2 et R3 ne sont pas intégrées au composant, la valeur du gain du circuit de traitement est alors réglable en modifiant la valeur des résistances.

Quel que soit le mode de réalisation du circuit de traitement selon l'invention, une application particulièrement intéressante concerne les dispositifs pour lesquels un signal est appliqué soit sur une première voie où un traitement numérique doit être effectué, soit sur une deuxième voie où aucun traitement numérique ne doit être effectué. Il est alors souvent nécessaire que le gain du signal soit sensiblement le même quelle que soit la voie empruntée par le signal.

Un exemple de dispositif tel que celui mentionné ci-dessus concerne un filtre de séparation des composantes luminance et chrominance de signal vidéo selon que le signal vidéo est de type PAL ou de type SECAM. Pour le signal de type PAL, la première voie est une voie filtrée, c'est-à-dire subissant une conversion analogique/numérique, un traitement numérique et une conversion numérique/analogique. Pour le signal de type SECAM, la deuxième voie est une voie ne subissant pas le traitement numérique mentionné ci-dessus et communément appelée voie "bypass". Le gain des deux voies doit être sensiblement le même.

Avantageusement, l'invention permet de réaliser un tel dispositif.

Les modes de réalisation de l'invention décrits ci-dessus concernent un circuit de contrôle de gain pour lequel le circuit de conversion analogique/numérique d'entrée est commandé en tension et le circuit numérique/analogique de sortie est commandé soit en tension, soit en courant. De façon plus générale, l'invention concerne un circuit de contrôle de gain de traitement numérique pour lequel le convertisseur analogique/numérique d'entrée est commandé soit en tension, soit en courant, de même que le convertisseur numérique/analogique de sortie.

**Revendications**

1. Circuit de traitement numérique comprenant :

   - un convertisseur analogique/numérique (1) situé en entrée du circuit,
   - un dispositif de traitement numérique (2) du signal issu du convertisseur analogique/numérique (1), et
   - un convertisseur numérique/analogique (3, 4) situé en sortie du circuit pour convertir le signal issu du dispositif de traitement numérique (2),

   **caractérisé en ce qu'**il comprend des moyens (A1, A2, R1, R2, R3, RS) pour contrôler le gain dudit circuit à partir d'une référence unique de tension VB de sorte que le gain dudit circuit est indépendant de la tension de référence VB.

2. Circuit de traitement selon la revendication 1 dans lequel le convertisseur numérique/analogique (3) situé en sortie est commandé en courant, **caractérisé en ce que** lesdits moyens de contrôle du gain comprennent :

   - un premier amplificateur (A2) de gain G2 fournissant la tension de commande V2 = G2 x VB du convertisseur analogique/numérique (1) ;
   - un amplificateur différentiel (A3) dont l'entrée positive est reliée à la tension VB et dont l'entrée négative est reliée, d'une part à la masse du circuit par l'intermédiaire d'une première résistance (R1) et, d'autre part à la source d'un transistor (T) dont la grille et le drain sont respectivement reliés à la sortie dudit l'amplificateur différentiel (A3) et au point du convertisseur numérique/analogique (3) d'où est extrait le courant de référence (Iref) ; et

   - une résistance de sortie (RS) reliée d'une part à la sortie (S) du circuit de traitement et d'autre part à la masse dudit circuit.

3. Circuit de traitement selon la revendication 1 dans lequel le convertisseur numérique/analogique (4) situé en sortie est commandé en tension, **caractérisé en ce que** lesdits moyens de contrôle du gain comprennent :

   - un premier amplificateur (A2) de gain G2 fournissant la tension de commande V2 = G2 x VB du convertisseur analogique/numérique (1) ; et
   - un amplificateur différentiel (A3) dont l'entrée positive est reliée à la tension VB et dont l'entrée négative est reliée, d'une part à la masse du circuit par l'intermédiaire d'une seconde résistance (R3) et, d'autre part à la sortie dudit l'amplificateur différentiel (A3) par l'intermédiaire d'une troisième résistance (R2), la sortie de l'amplificateur différentiel étant reliée à la commande de référence du convertisseur numérique/analogique (4).

4. Circuit de traitement selon l'une des revendications précédentes, **caractérisé en ce que** la référence de tension VB est une tension de « bandgap ».

5. Circuit de traitement selon l'une des revendications 2 ou 3, **caractérisé en ce que** le convertisseur analogique/numérique (1), le dispositif de traitement numérique (2), le convertisseur numérique/analogique (3, 4), le premier amplificateur (A2) et l'amplificateur différentiel (A3) sont réalisés sur un même composant en technologie CMOS.

6. Circuit de traitement selon la revendication 5 prise dans sa dépendance de la revendication 2, **caractérisé en ce que** le transistor (T) est réalisé en technologie CMOS sur ledit même composant.

7. Circuit de traitement selon la revendication 6, **caractérisé en ce que** la première résistance (R1) et la résistance de sortie (RS) sont réalisées en technologie CMOS sur ledit même composant.

8. Circuit de traitement selon la revendication 5 prise dans sa dépendance de la revendication 3, **caractérisé en ce que** la seconde (R3) et la troisième (R2) résistance sont réalisées en technologie CMOS sur ledit même composant.

9. Circuit de traitement selon la revendication 5, **caractérisé en ce qu'**au moins une des résistance est extérieure audit même composant de façon à pouvoir régler le gain dudit circuit de traitement.

**Patentansprüche**

1. Digitale Verarbeitungsschaltung mit:

   - einem Analog/Digital-Konverter (1) am Eingang der Schaltung,
   - einer Einheit (2) zur digitalen Verarbeitung des Signals von dem Analog/Digital-Konverter (1) und
   - einem Digital/Analog-Konverter (3, 4) am Ausgang der Schaltung zur Umsetzung des Signals von der Einheit (2) zur digitalen Verarbeitung,

   **gekennzeichnet durch**
   Mittel (A1, A2, R1, R2, R3, RS) zur Verstärkungsregelung der Schaltung aus einer einzigen Referenzspannung VB derart, daß die Verstärkung der Schaltung von der Referenzspannung VB unabhängig ist.

2. Verarbeitungsschaltung nach Anspruch 1, in der der Digital/Analog-Konverter (3) am Ausgang stromgesteuert ist, **dadurch gekennzeichnet, daß** die Mittel zur Verstärkungsregelung folgendes enthalten:

   - einen ersten Verstärker (A2) mit der Verstärkung G2, der die Steuerspannung V2 = G2 x VB des Analog/Digital-Konverters (1) liefert,
   - einen Differenzverstärker (A3), dessen nicht-invertierender Eingang mit der Spannung VB und dessen invertierender Eingang über einen ersten Widerstand (R1) mit Schaltungserde und andererseits mit dem Source eines Transistors (T) verbunden ist, dessen Basis und Drain jeweils mit dem Ausgang des Differenzverstärkers (A3) bzw. einem Punkt des Digital/Analog-Konverters (3) verbunden ist, von wo der Referenzstrom (Iref) extrahiert wird, und
   - einen Ausgangswiderstand (RS), der einerseits mit dem Ausgang (S) der Verarbeitungsschaltung und andererseits mit Schaltungserde verbunden ist.

3. Verarbeitungsschaltung nach Anspruch 1, in der der DIgital/Analog-Konverter (4) am Ausgang spannungsgesteuert ist, **dadurch gekennzeichnet, daß** die Mittel zur Regelung der Verstärkung folgendes enthalten:

   - einen ersten Verstärker (A2) mit der Verstärkung G2, der die Steuerspannung V2 = G2 x VB des Analog/Digital-Konverters (1) liefert, und
   - einen Differenzverstärker (A3), dessen nicht-invertierender Eingang mit der Spannung VB und dessen invertierender Eingang einerseits mit Schaltungserde über einen zweiten Widerstand (R3) und andererseits mit dem Ausgang des Differenzverstärkers (A3) über einen dritten Widerstand (R2) verbunden ist, und daß der Ausgang des Differenzverstärkers mit der Referenzsteuerung des Digital/Analog-Konverters (4) verbunden ist.

4. Verarbeitungsschaltung nach einem der vorangehenden Ansprüche, **dadurch gekennzeichnet, daß** die Referenzspannung VB eine "Bandgap"-Spannung ist.

5. Verarbeitungsschaltung nach einem der Ansprüche 2 oder 3, **dadurch gekennzeichnet, daß** der Analog/Digital-Konverter (1) die Einheit (2) zur digitalen Verarbeitung, der Digital/Analog-Konverter (3, 4), der erste Verstärker (A2) und der Differenzverstärker (A3) auf derselben Komponente in CMOS-Technologie ausgebildet sind.

6. Verarbeitungsschaltung nach Anspruch 5 und 2, **dadurch gekennzeichnet, daß** der Transistor (T) in CMOS-Technologie auf demselben Substrat ausgebildet ist.

7. Verarbeitungsschaltung nach Anspruch 6, **dadurch gekennzeichnet, daß** der erste Widerstand (R1) und der Ausgangswiderstand (RS) in CMOS-Technologie auf demselben Substrat ausgebildet sind.

8. Verarbeitungsschaltung nach Anspruch 3 und 5, **dadurch gekennzeichnet, daß** der zweite (R3) und der dritte (R2) Widerstand in CMOS-Technologie auf demselben Substrat ausgebildet sind.

9. Verarbeitungsschaltung nach Anspruch 5, **dadurch gekennzeichnet, daß** wenigstens einer der Widerstände extern zu demselben Substrat liegt, damit er die Verstärkung der Verarbeitungsschaltung regeln kann.

**Claims**

1. Digital processing circuit comprising :

   - an analogue / digital converter (1) situated at the input of the circuit,

- a device (2) for the digital processing of the signal emanating from the analogue / digital converter (1), and
- a digital / analogue converter (3, 4) situated at the output of the circuit for converting the signal emanating from the digital processing device (2),

   **characterized in that** it comprises means (A1, A2, R1, R2, R3, RS) for controlling the gain of said circuit from a single voltage reference VB such that the gain of said circuit is independent of the voltage reference VB.

2. Processing circuit according to claim 1 in which the digital /analogue converter (3) situated at the output is current-controlled,
   **characterized in that** said means for controlling the gain comprise :

   - a first amplifier (A2) of the gain G2 supplying the control voltage V2=G2xVB of the analogue digital converter (1);
   - a differential amplifier (A3) whose positive input is connected to the voltage VB and whose negative input is connected, on the one hand to the earth of the circuit by way of a first resistor (R1) and, on the other hand to the source of a transistor (T) whose gate and drain are respectively connected to the output of said differential amplifier (A3) and to the point of the digital / analogue converter (3) from which the reference current (Iref) is extracted; and
   - an output resistor (RS) connected on the one hand to the output (S) of the processing circuit and, in the other hand to the earth of said circuit.

3. Processing circuit according to claim 1 in which the digital /analogue converter (4) situated at the output is voltage-controlled,
   **characterized in that** said means for controlling the gain comprise :

   - a first amplifier (A2) of gain G2 supplying the control voltage V2=G2xVB of the analogue / digital converter (1); and
   - a differential amplifier (A3) whose positive input is connected to the voltage VB and whose negative input is connected, on the one hand to the earth of the circuit by way of the second resistor (R3) and, on the other hand to the output of said differential amplifier (A3) by way of the third resistor (R2), the output of the differential amplifier being connected to the reference control of the digital / analogue converter (4).

4. Processing circuit according to any one of the preceding claims,

   **characterized in that** the voltage reference VB is a bandgap voltage.

5. Processing circuit according to one of claims 2 or 3, **characterized in that** the analogue / digital converter (1), the digital processing device (2), the digital / analogue converter (3, 4), the first amplifier (A2), the differential amplifier (A3) are made on one and the same component in CMOS technology.

6. Processing circuit according to claim 5 depending on claim 2,
   **characterized in that** the transistor (T) is made in CMOS technology on said same component.

7. Processing circuit according to claim 6, **characterized in that** the first resistor (R1) and the output resistor (RS) are made in CMOS technology on said same component.

8. Processing circuit according to claim 5 depending on claim 3,
   **characterized in that** the second (R3) and the third (R2) resistor are made in CMOS technology on said same component.

9. Processing circuit according to claim 5, **characterized in that** at least one of the resistors is outside the said same component so as to be able to adjust the gain of the processing circuit.

**FIG.1**

EP 0 782 272 B1

FIG.2